# EUROPEAN PATENT APPLICATION

(11) **EP 4 807 488 A1**
(43) Date of publication of application: **16.09.2026**
(21) Application number: 26155882.9
(22) Date of filing: 03.02.2026
(51) Int. Cl.: G05D 1/80

(54) **AI-BASED SYSTEM AND METHOD FOR SAFE CONTROL GENERATION FOR UNMANNED AERIAL SYSTEM APPLICATIONS**

(30) Priority: 10.03.2025 US 202519075633
(71) Applicant: Hitachi, Ltd., Tokyo 100-8280 (JP)
(72) Inventor: THAPLIYAL, Omanshu, Tokyo, 100-8280 (JP); SANKARANARAYANASAMY, Malarvizhi, Tokyo, 100-8280 (JP); VENNELAKANTI, Ravigopal, Tokyo, 100-8280 (JP)
(74) Representative: MERH-IP Matias Erny Reichl Hoffmann Patentanwälte PartG mbB

(57) **Abstract**

Systems and methods described perform AI-driven safe control generation for unmanned aerial systems (UASs) using a simulator or scenario generator that creates candidate trajectories subject to system constraints; a plant simulator that functions as a machine learning-based digital twin of the UAS dynamical model under conditions of uncertainty, where behavior is not fully predictable; a model checker that employs Boolean logic representations of safety requirements and a machine learning module that is pre-trained on Boolean outputs derived from simulated trajectories sampled offline in simulated environments; and a hierarchical AI-based control module that provides an additional safety layer. In embodiments, this is accomplished by performing model checks and providing alternative control inputs in potentially unsafe scenarios. The hierarchical control module assists onboard controllers by supplementing traditional control systems with alternative inputs when unsafe conditions are detected, without overriding primary actuator signals.

## Description

### BACKGROUND

### Field

The present disclosure is generally directed to generating safe control mechanisms for autonomous unmanned aerial systems (UASs), and more specifically, to AI-based systems and methods that enable autonomous safe control generation for UASs using machine learning and Boolean logic-based model checking for advanced aerial mobility applications.

### Related Art

UASs are anticipated to form the foundational infrastructure of advanced or urban air mobility (AAM/UAM) for high-speed, low-altitude, and cost-effective aerial transport of cargo and passengers. Achieving this requires highly autonomous solutions in areas such as path planning, obstacle avoidance, safe operational integrity, and electric vertical take-off and landing (e-VTOL) functionalities.

Especially for e-VTOL UASs, safe control remains a critical challenge that requires a framework capable of verifying controller outputs both in simulation and real-time environments for UAM stakeholders including operators, manufacturers, regulatory agencies, and end-users. However, the rise of non-deterministic, black-box approaches in AI and machine learning (AI/ML) introduces unpredictability under safety-critical scenarios. Instead of supplanting traditional model-based, physics-grounded control systems, there is an urgent need to employ AI/ML methods to enhance existing systems for UAS autonomous operations.

Existing approaches in related fields primarily address safety by either relegating control to a human operator during anomalies or by assuming that external measurements and data from various sensors determine safe zones. For example, autonomous road vehicles incorporate systems for safe control relying on external data, with failsafe mechanisms reverting to human control in critical conditions. Similarly, UAV communication ecosystems and UAS flight control systems focus on maintaining safe operational zones relative to external factors like restricted airspaces or nearby obstacles, but they do not actively define or quantify the "safe zones" autonomously.

These existing approaches lack methods for autonomous, data-driven determination of safe zones, with most requiring human oversight or external validation. In contrast, the present disclosure provides systems and methods that autonomously define, quantify, and predict safe operational conditions for UASs through machine learning and Boolean logic, obviating the need for externally imposed safety parameters.

### SUMMARY

In some aspects of the disclosure, a system for generating safe control for a UAS comprises: a scenario generator configured to output candidate trajectories for a UAS based on system constraints that may comprise a regulation or a policy that comprises an obstacle avoidance, a path planning, an actuator limit, or a flight dynamic; a machine learning-based plant simulator configured to use the candidate trajectories and historical UAS data to simulate a UAS behavior under one or more conditions along each trajectory and to generate a simulated trajectory for each; a model checker configured to: use a Boolean logic or a temporal logic to convert a safety requirement from natural language into a safety classification that is machine-readable and improved through incremental learning with new data presented; evaluate the simulated trajectory in real time against the safety classification; and apply the safety classification to UAS dynamics to identify a subset of trajectories as safe trajectories; a UAS control schema that, in response to receiving the safe trajectories and associated control inputs, uses a control input processor to translate each safe trajectory into actuator commands and communicates these to a UAS actuator to adjust a UAS parameter, such as a speed limit, an altitude restriction, a distance from obstacles, a weather condition, or an orientation, to guide the UAS along a safe trajectory; a hierarchical control layer configured to monitor real-time operational parameters of the UAS and, in response to detecting a potential safety violation associated with the safe trajectory, adjusts the control inputs by issuing alternative commands, thereby augmenting the UAS control schema to prevent unsafe conditions without overriding functions of the UAS control schema; and a communication interface that enables real-time feedback among the hierarchical control layer, the model checker, and the control input processor to adjust a command based on real-time operational data that is communicated by the model checker to the UAS, wherein the hierarchical control layer is selectively activated when a safety risk or trajectory deviation is identified within a planning horizon to ensure compliance with the safety requirement.

Some aspects may further comprise a logging system configured to record control decisions, safety classifications, trajectory data, real-time operational adjustments, and historical UAS data, which comprises control input data, the trajectory data, or an environmental factor, to enable a post-mission analysis of control performance.

In some aspects, simulating the UAS dynamics may comprise using historical trajectory data and real-time operational data from one or more UAS sensors, which comprise LiDAR, RADAR, GPS/GNSS, or an optical flow sensor; and simulating the UAS behavior comprises simulating a state variable that comprises a position, an orientation.

In some aspects, the alternative commands may be pre-approved by the model checker.

In some aspects, outputting the subset of trajectories comprises communicating corresponding control inputs to the UAS control schema.

In some aspects, the machine learning-based plant simulator is trained on historical control input sequences and corresponding UAS trajectories; is updated using real-time operational data from UAS sensors to improve dynamic modeling accuracy under differing environmental conditions; and incorporates actuator saturation limits and UAS constraints into dynamic modeling to ensure realistic control simulations.

In some aspects, the hierarchical control layer comprises a lower-level control layer that directly interacts with a UAS actuator and a higher-level control layer that manages trajectory planning, and reverts to an on-board UAS controller when no unsafe behavior is detected. The hierarchical control layer may communicate with the model checker to obtain real-time feedback on the safety of an ongoing UAS operation, the hierarchical control system being capable of operating in both manual override and autonomous modes depending on a level of detected risk.

In some aspects, the techniques described herein relate to a method for generating safe control for a UAS comprising: based on one or more system constraints, generating candidate trajectories for a UAS; using the candidate trajectories and historical UAS data to simulate a UAS behavior under one or more conditions along each trajectory and to generating a simulated trajectory for each; using a Boolean logic or a temporal logic to convert a safety requirement from natural language into a safety classification that is machine-readable format and improved through incremental learning with new data presented; evaluating the simulated trajectory in real time against the safety classification; applying the safety classification to UAS dynamics to identify a subset of trajectories as safe trajectories in response to receiving the safe trajectories and control inputs associated therewith, translating each safe trajectory into actuator commands and to communicate the actuator commands to a UAS actuator to adjust a UAS parameter to guide the UAS along a safe trajectory; monitoring real-time operational parameters of the UAS using a hierarchical control layer and, in response to detecting a potential safety violation associated with the safe trajectory, adjusting the control inputs by issuing alternative commands, thereby augmenting a UAS control schema to prevent unsafe conditions without overriding functions of the UAS control schema; adjusting a command based on real-time operational data that is communicated to the UAS; and in response to detecting a safety risk or trajectory deviation within a planning horizon, selectively activating the hierarchical control layer to ensure compliance with the safety requirement.

Some aspects may further comprise logging control decisions, safety classifications, trajectory data, real-time operational adjustments, and the historical UAS data, comprising control input data, trajectory data, or environmental factors, to enable a post-mission analysis of control performance.

In some aspects, the techniques described herein relate to a method, further including simulating the UAS dynamics using historical trajectory data and real-time operational data from UAS sensors, comprising LiDAR, RADAR, GPS/GNSS, or optical flow sensors, to improve accuracy in dynamic modeling.

Some aspects may further comprise training a machine learning-based plant simulator on historical control input sequences and corresponding UAS trajectories to enhance model reliability; using real-time the operational data from the UAS sensors to update the machine learning-based plant simulator and improve dynamic modeling accuracy under varied environmental conditions; incorporating actuator saturation limits and UAS constraints into dynamic modeling to ensure realistic control simulations; converting safety requirements from certification, regulatory, or operational standards into machine-readable Boolean or temporal logic statements to facilitate safety compliance evaluation within a model checker; and selecting candidate control inputs based on pre-trained Boolean logic classifiers, which assess trajectory safety in real time to retain only those control inputs associated with the safe trajectories.

Aspects of the present disclosure can involve a system, which can involve means for generating candidate trajectories for a UAS based on system constraints; means for using the candidate trajectories and historical UAS data to simulate a UAS behavior under one or more conditions along each trajectory and to generating a simulated trajectory for each; means for using a Boolean logic or a temporal logic to convert a safety requirement from natural language into a safety classification that is machine-readable format and improved through incremental learning with new data presented; means for evaluating the simulated trajectory in real time against the safety classification; means for applying the safety classification to UAS dynamics to identify a subset of trajectories as safe trajectories in response to receiving the safe trajectories and control inputs associated therewith, translating each safe trajectory into actuator commands and to communicate the actuator commands to a UAS actuator to adjust a UAS parameter to guide the UAS along a safe trajectory; means for monitoring real-time operational parameters of the UAS using a hierarchical control layer and, in response to detecting a potential safety violation associated with the safe trajectory, adjusting the control inputs by issuing alternative commands, thereby augmenting a UAS control schema to prevent unsafe conditions without overriding functions of the UAS control schema; means for adjusting a command based on real-time operational data that is communicated to the UAS; and means for selectively activating the hierarchical control layer, in response to detecting a safety risk or trajectory deviation within a planning horizon, to ensure compliance with the safety requirement.

### BRIEF DESCRIPTION OF DRAWINGS

FIG. 1 illustrates an exemplary system for generating safe control for a UAS, according to various embodiments of the present disclosure.
FIG. 2 illustrates an exemplary UAS control schema, according to various embodiments of the present disclosure.
FIG. 3 illustrates a plant simulator according to various embodiments of the present disclosure.
FIG. 4 illustrates a model checker according to various embodiments of the present disclosure.
FIG. 5 illustrates a hierarchical control according to various embodiments of the present disclosure.
FIG. 6 is a flowchart illustrating an exemplary process for generating safe control for a UAS in accordance with various embodiments of the present disclosure.
FIG. 7 illustrates an example computing environment with an example computer device suitable for use in some example implementations.

### DETAILED DESCRIPTION

The following detailed description provides details of the figures and example implementations of the present application. Reference numerals and descriptions of redundant elements between figures are omitted for clarity. Terms used throughout the description are provided as examples and are not intended to be limiting. For example, the use of the term "automatic" may involve fully automatic or semi-automatic implementations involving user or administrator control over certain aspects of the implementation, depending on the desired implementation of one of ordinary skill in the art practicing implementations of the present application. Selection can be conducted by a user through a user interface or other input means, or can be implemented through a desired algorithm. Example implementations as described herein can be utilized either singularly or in combination and the functionality of the example implementations can be implemented through any means according to the desired implementations. In this document, the terms "simulator" and "scenario generator" are used interchangeably.

The problem of safe, autonomous control of unmanned aerial systems is complex, given the number of stakeholders in UASs and UAM sectors and a system-of-systems environment. Autonomous control must address collision avoidance, path planning, contingency handling, situational awareness, cybersecurity, public safety and reliability perception, and regulatory compliance.

Methods trained to emulate system behavior as closely as possible can be utilized for simultaneous simulation of the system under hundreds of trajectories to select those that are deemed safe. Further, vernacular concepts (natural language) of safety can be encapsulated or embedded into Boolean language to be utilized to train machine learning modules for classification of safe vs. unsafe behaviors of the UAS across possible control inputs. As discussed in greater detail below, safety requirements, such as rotor limits, climb rates, and landing constraints, may be converted into Boolean logic to enable machine learning modules to classify UAS behavior.

Customized safety requirements may be utilized to train an AI model to learn and simulate safe-unsafe UAS behaviors. Such training enables a system to create certifiably safe trajectories for UAS operations, considering external disturbances like wind gusts, etc.

Accordingly, various systems and methods herein utilize AI-modules to represent safety requirements in a manner utilizable by computer algorithms, predict UAS trajectories via simultaneous simulation of UAS dynamics, and provide alternative control schemes in case on-board lower-level control leads to unsafe conditions, e.g., to augment existing control methodologies in UAS autonomy. The described systems incorporate AI modules to represent safety criteria, predict UAS trajectories under multiple simulated scenarios, and provide alternative control options when onboard controllers are insufficient to maintain safety.

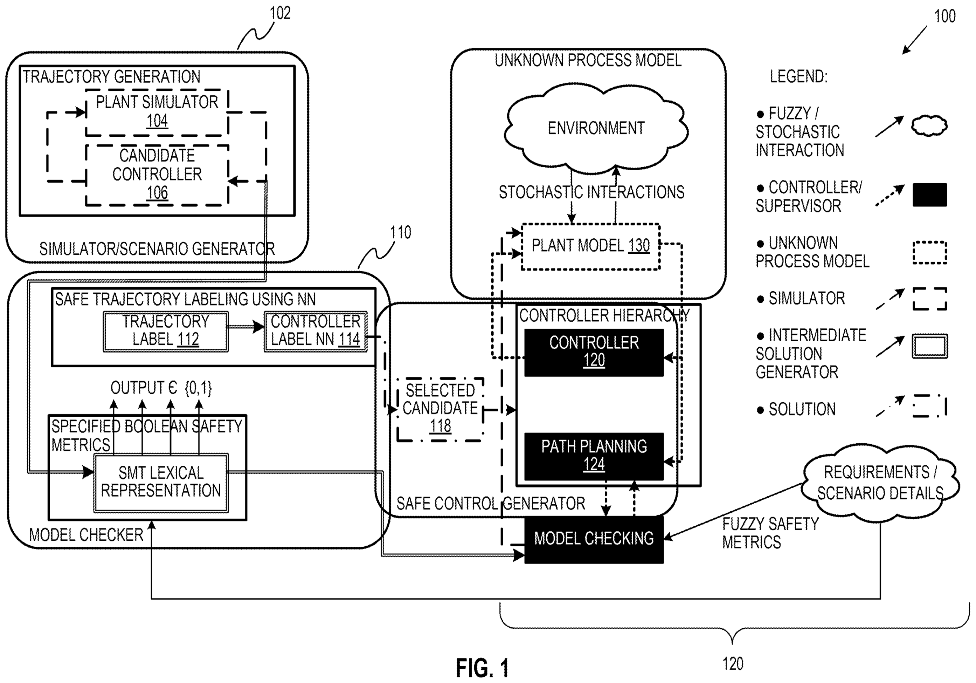

FIG. 1 illustrates an exemplary system for generating safe control for a UAS according to various embodiments of the present disclosure. Interactions between modules are highlighted in the legend. As depicted, system 100 may comprise scenario generator 102 that may comprise plant simulator 104, which generates candidate trajectories subject to system constraints, and candidate controller 106; model checker 110, which may use trajectory label 112 and controller label 114 for safe trajectory labeling; and UAS control schema 120. In embodiments, scenario generator 102 may utilize an auxiliary model of UAS control schema 120, comprising controller 120 and path planning 124 that receive selected candidates 118 and communicate with plant model 130.

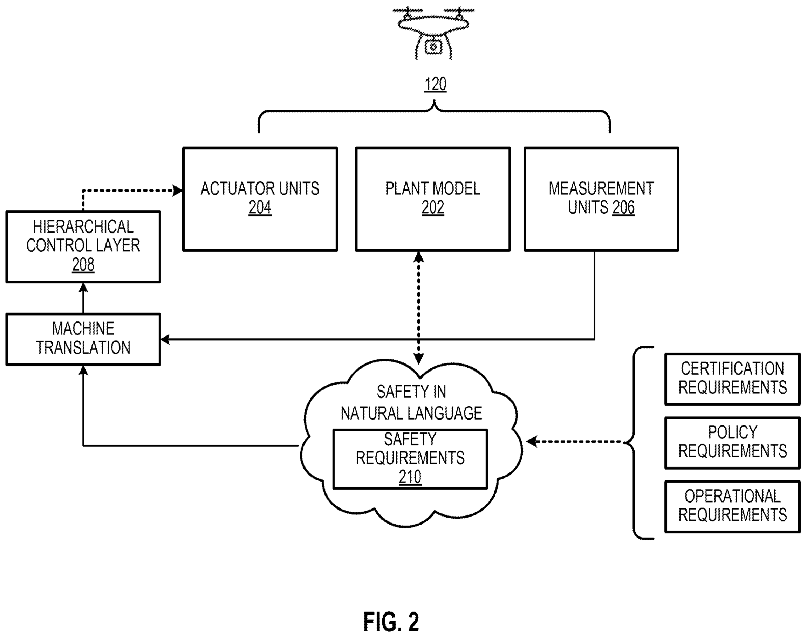

As shown in FIG. 2, UAS control schema 120 comprises plant model 202, actuator unit 204, and measurement unit 206. In operation, plant model 202 describes internal dynamics of a UAS, which may serve as a functional mapping from the input space, such as actuator control input to the UAS, e.g., commanded RPM or torque to the four motors on a quadrotor, to the state space, e.g., 3-dimensional spatial coordinates of the UAS, its roll, pitch, and yaw, and their corresponding rates of change. Actuator unit 204 may represent dynamical models of actuators. For example, four motors that control the torque on a quadrotor's rotors, or the motor torque/voltage for the control surfaces, such as ailerons, rudders, and flaps, of a fixed wing UAS. Measurement unit 206 may comprise any number of sensors used to measure the UAS's state, such as optical flow sensors, camera units, LiDAR/RADAR, and GPS/GNSS sensors.

In embodiments, hierarchical control layer 208 may communicate lower-level commands, such as motor voltage, to an actuator to achieve a higher-level, abstract goal, such as obstacle avoidance.

In embodiments, safety requirements 210 arising from certification, policy, and operational requirements may be translated into machine-readable formats. For instance, natural language descriptions of safety requirements may be converted into Boolean or temporal logic statements. As an example, a safety requirement expressed in natural language, such as "rotor limits ±*p* rpm, climb rate cannot exceed q ft/s, while safely landing on a vertiport of size *R* ft, within operating time" may be expressed in Boolean language via Boolean logic/temporal logic as: $\left(\left‖rpm_i\right‖\leq p\right) ∧ \left(\dot{h}\leq q\right) ∧ \left(∀d∈D,∃u∈U,x\to R,as t\to T\right)$
wherein Subscript *i* corresponds to the *i*^{th} rotor; *D* represents the possible disturbance set for given exogeneous disturbance *d;* for control input *u,* the admissible control set is *U; and T* represents mission time.

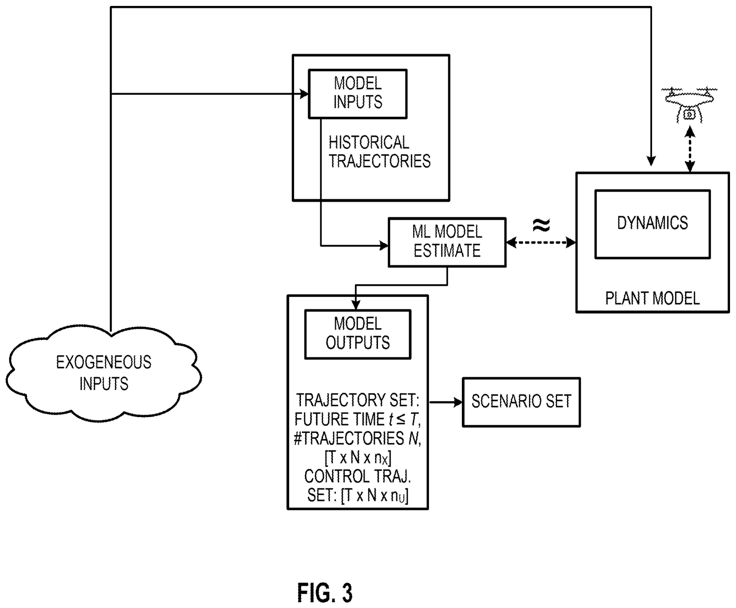

FIG. 3 illustrates a plant simulator according to various embodiments of the present disclosure. In embodiments, the plant simulator operates as a machine learning-based digital twin of UAS dynamics, trained on historical trajectories and control inputs to approximate UAS behavior under varied conditions. The exact dynamical model of the plant is rarely fully known for all scenarios. In addition, exact differential equations often fail to accurately represent real-time UAS behavior under constrained actuator inputs, saturations, and state constraints (e.g., no-go zones).

In embodiments, the plant simulator may serve as an approximate machine learning estimate of the UAS's underlying dynamics. In embodiments, the machine learning model estimate may be obtained by pairing historical trajectories with the control input sequences that generated them. This collection of paired inputs and resulting trajectories forms a scenario set. Numerous scenario sets are employed to train the machine learning model to estimate plant dynamics across varying operational conditions, with model training performed offline or at the end of each mission.

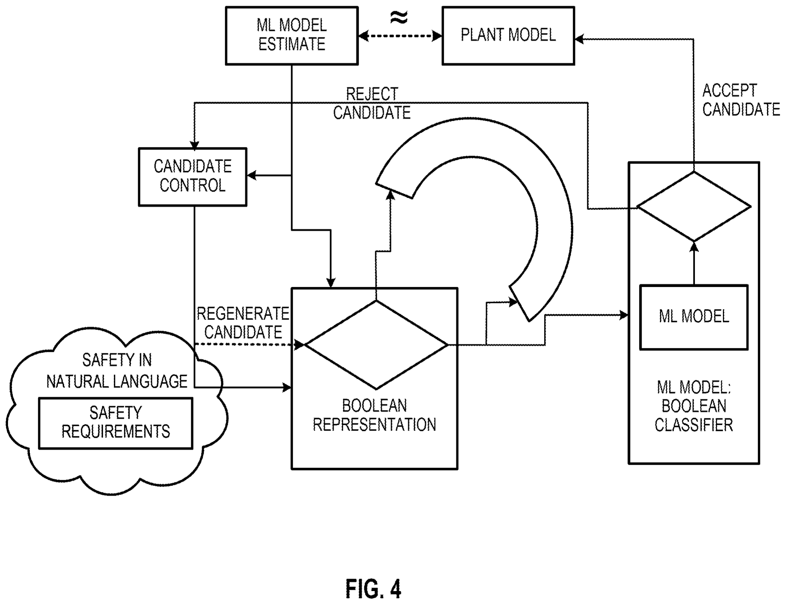

FIG. 4 illustrates a model checker according to various embodiments of the present disclosure. In embodiments, the model checker may utilize pre-trained Boolean logic classifiers to assess trajectory safety in real-time and interact with the plant simulator, e.g., by passing a bank of candidate controls. In embodiments, these controls may generate future trajectories under the learned machine learning model, which are then evaluated against the Boolean safety representations. In embodiments, trajectories that are deemed safe based on candidate controls may be retained, along with the corresponding control inputs. These selected trajectories and control inputs interact with the UAS control schema.

In embodiments, the Boolean representation of safety may be used to retrain the safety discrimination logic at the end of each mission.

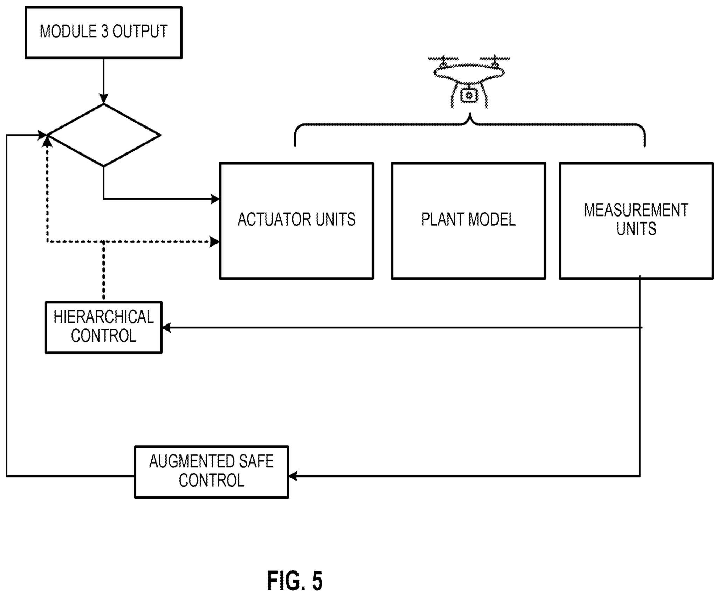

FIG. 5 illustrates a hierarchical control according to various embodiments of the present disclosure. The resultant AI-based control input to the UAS need not replace on-board control actuator control signals, but may instead augment the on-board control schema, e.g., by placing them under a separate layer of model, checking to provide alterative control when lower-level control might lead to unsafe conditions. Selected candidate outputs of the model checker may be used to augment the hierarchical control.

In embodiments, when a current control sequence does not result in unsafe conditions within a planning horizon, a candidate control command from the model checker may simply be rejected, thereby allowing the hierarchical control layer to remain active. Otherwise, candidate control sequences may enhance the hierarchical control currently in place on the UAS. Stated differently, when no projected wrong/unsafe conditions arise within the planning horizon, the control philosophy is to "not rock the boat," such that the AI-based safe control design schema activates only if the current control trajectory is projected to lead to an unsafe state of the UAS.

Advantageously, the proposed methods and systems for safe control generation does not replace on-board autonomy solutions or algorithms for UAS autonomy; instead, they augment the already existing controllers.

The learned models may be refined over time, with updates processed offline. Advantageously, these models can also be deployed onboard to enhance existing control algorithms. The proposed methods and systems may utilize machine representations of 'fuzzy' safety requirements and provide a structured approach to incorporating requirements from policies, operational requirements, system constraints, and certification standards into training machine learning models for safe/unsafe behavior prediction in UAS.

In embodiments, candidate controls may be included into lower-level hierarchical control (e.g., generating direct actuator commands), or higher-level control functions (e.g., path planning under uncertainties).

In embodiments, existing standard control procedures (e.g., system identification) may be included as they are or be replaced by pretrained model checkers that are trained on trajectory simulation data, helping to manage the computational load required for real time analytical computation.

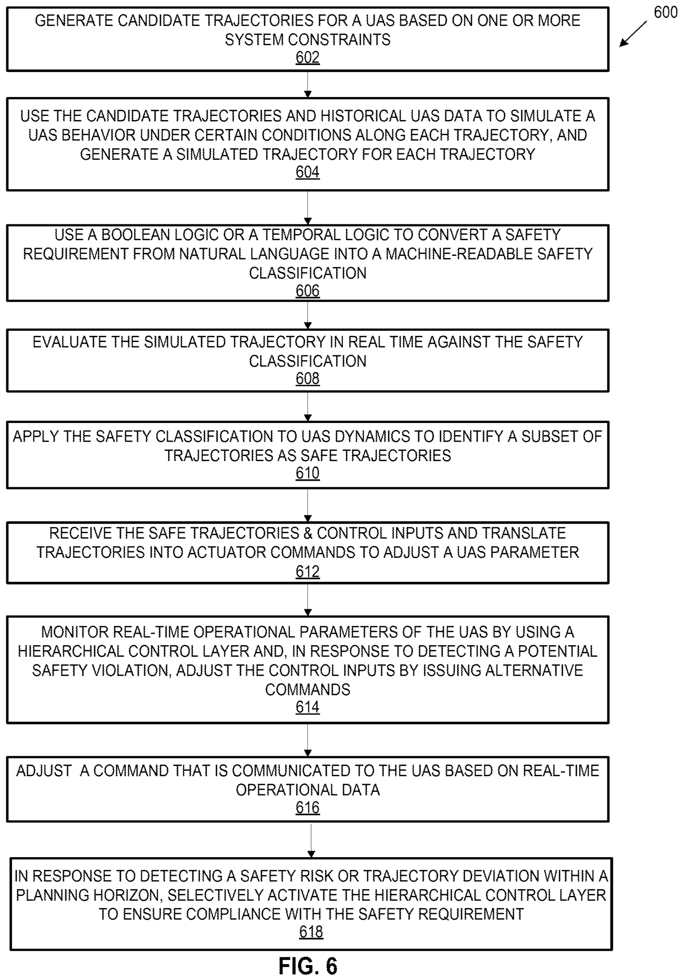

FIG. 6 is a flowchart illustrating an exemplary process for generating safe control for a UAS in accordance with various embodiments of the present disclosure. In embodiments, process 600 may start at step 602, when candidate trajectories are generated for a UAS based on one or more system constraints.

At step 604, the candidate trajectories and historical UAS data may be used to simulate a UAS behavior under certain conditions along each trajectory. And a simulated trajectory may be generated for each trajectory.

At step 606, a Boolean logic or a temporal logic may be used to convert a safety requirement from natural language into a machine-readable safety classification that is improved through incremental learning with new data presented.

At step 608, the simulated trajectory may be evaluated in real time against the safety classification.

At step 610, the safety classification may be applied to UAS dynamics, e.g., to identify a subset of trajectories as safe trajectories.

At step 612, in response to receiving the safe trajectories and control inputs associated therewith, each safe trajectory may be translated into actuator commands that may be communicated to a UAS actuator, e.g., to adjust a UAS parameter to guide the UAS along a safe trajectory.

At step 614, real-time operational parameters of the UAS may be monitored by using a hierarchical control layer and, in response to detecting a potential safety violation associated with the safe trajectory, the control inputs may be adjusted, e.g., by issuing alternative commands. In this manner, the UAS control schema can be augmented to prevent unsafe conditions without overriding functions of the UAS control schema.

At step 616, a command based on real-time operational data that is communicated to the UAS may be adjusted.

Finally, at step 618, in response to detecting a safety risk or trajectory deviation within a planning horizon, the hierarchical control layer may be selectively activated to ensure compliance with the safety requirement.

One skilled in the art shall recognize that: (1) certain steps may optionally be performed; (2) steps may not be limited to the specific order set forth herein; (3) certain steps may be performed in different orders; and (4) certain steps may be done concurrently.

It is noted that although the invention is generally described in the context of generating safe control for UASs, it is understood that this is not intended to limit the scope of the present disclosure to such embodiments as the safe control generating systems and methods described herein may be used in any other context.

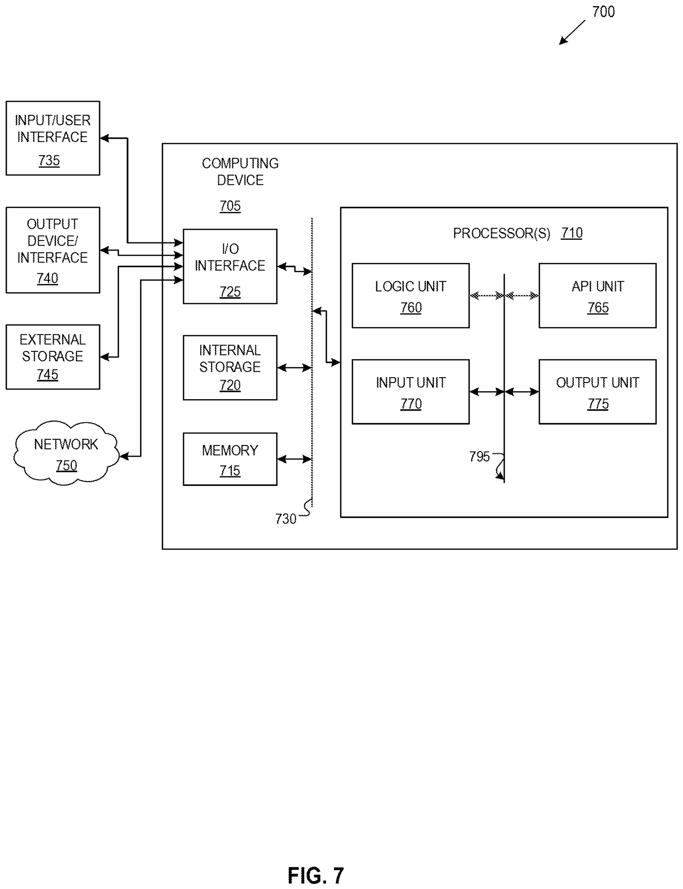

FIG. 7 illustrates an example computing environment with an example computer device suitable for use in some example implementations, according to various embodiments of the present disclosure. Computer device 705 in computing environment 700 can include one or more processing units, cores, or processors 710, memory 715 (e.g., RAM, ROM, and/or the like), internal storage 720 (e.g., magnetic, optical, solid-state storage, and/or organic), and/or I/O interface 725, any of which can be coupled on a communication mechanism or bus 730 for communicating information or embedded in the computer device 705. I/O interface 725 is also configured to receive images from cameras or provide images to projectors or displays, depending on the desired implementation.

Computer device 705 can be communicatively coupled to input/user interface 735 and output device/interface 740. Either one or both of input/user interface 735 and output device/interface 740 can be a wired or wireless interface and can be detachable. Input/user interface 735 may include any device, component, sensor, or interface, physical or virtual, that can be used to provide input (e.g., buttons, touch-screen interface, keyboard, a pointing/cursor control, microphone, camera, braille, motion sensor, optical reader, and/or the like). Output device/interface 740 may include a display, television, monitor, printer, speaker, braille, or the like. In some example implementations, input/user interface 735 and output device/interface 740 can be embedded with or physically coupled to the computer device 705. In other example implementations, other computer devices may function as or provide the functions of input/user interface 735 and output device/interface 740 for a computer device 705.

Examples of computer device 705 may include highly mobile devices (e.g., smartphones, devices in vehicles and other machines, devices carried by humans and animals, and the like), mobile devices (e.g., tablets, notebooks, laptops, personal computers, portable televisions, radios, and the like), and devices not designed for mobility (e.g., desktop computers, other computers, information kiosks, televisions with one or more processors embedded therein and/or coupled thereto, radios, and the like).

Computer device 705 can be communicatively coupled (e.g., via I/O interface 725) to external storage 745 and network 750 for communicating with any number of networked components, devices, and systems, including one or more computer devices of the same or different configurations. Computer device 705 or any connected computer device can be functioning as, providing services of, or referred to as a server, client, thin server, general machine, special-purpose machine, or another label.

I/O interface 725 can include wired and/or wireless interfaces using any communication or I/O protocols or standards (e.g., Ethernet, 802.11x, Universal System Bus, WiMax, modem, a cellular network protocol, and the like) for communicating information to and/or from at least all the connected components, devices, and network in computing environment 700. Network 750 can be any network or combination of networks (e.g., the Internet, local area network, wide area network, a telephonic network, a cellular network, a satellite network, and the like).

Computer device 705 can use and/or communicate using computer-usable or computer-readable media, including transitory media and non-transitory media. Transitory media include transmission media (e.g., metal cables, fiber optics), signals, carrier waves, and the like. Non-transitory media include magnetic media (e.g., disks and tapes), optical media (e.g., CD ROM, digital video disks, Blu-ray disks), solid-state media (e.g., RAM, ROM, flash memory, solid-state storage), and other non-volatile storage or memory.

Computer device 705 can be used to implement techniques, methods, applications, processes, or computer-executable instructions in some example computing environments. Computer-executable instructions can be retrieved from transitory media, and stored on and retrieved from non-transitory media. The executable instructions can originate from one or more of any programming, scripting, and machine languages (e.g., C, C++, C#, Java, Visual Basic, Python, Perl, JavaScript, and others).

Processor(s) 710 can execute under any operating system (OS) (not shown), in a native or virtual environment. One or more applications can be deployed that include logic unit 760, application programming interface (API) unit 765, input unit 770, output unit 775, and inter-unit communication mechanism 795 for the different units to communicate with each other, with the OS, and with other applications (not shown). The described units and elements can be varied in design, function, configuration, or implementation and are not limited to the descriptions provided. Processor(s) 710 can be in the form of hardware processors such as central processing units (CPUs) or a combination of hardware and software units.

In some example implementations, when information or an execution instruction is received by API unit 765, it may be communicated to one or more other units (e.g., logic unit 760, input unit 770, output unit 775). In some instances, logic unit 760 may be configured to control the information flow among the units and direct the services provided by API unit 765, input unit 770, and output unit 775, in some example implementations described above. For example, the flow of one or more processes or implementations may be controlled by logic unit 760 alone or in conjunction with API unit 765. The input unit 770 may be configured to obtain input for the calculations described in the example implementations, and the output unit 775 may be configured to provide output based on the calculations described in example implementations.

Processor(s) 710 can be configured to execute a method or computer instructions which can involve generating candidate trajectories for a UAS based on system constraints; using the candidate trajectories and historical UAS data to simulate a UAS behavior under one or more conditions along each trajectory and to generating a simulated trajectory for each, as described, for example, with respect to FIG. 1 through FIG. 3, and using a Boolean logic or a temporal logic to convert a safety requirement from natural language into a safety classification that is machine-readable format, as described, for example, with respect to FIG. 2 and FIG. 6.

Processor(s) 710 can be configured to execute a method or computer instructions which can involve evaluating the simulated trajectory in real time against the safety classification; applying the safety classification to UAS dynamics to identify a subset of trajectories as safe trajectories in response to receiving the safe trajectories and control inputs associated therewith, translating each safe trajectory into actuator commands and to communicate the actuator commands to a UAS actuator to adjust a UAS parameter to guide the UAS along a safe trajectory; monitoring real-time operational parameters of the UAS using a hierarchical control layer and, in response to detecting a potential safety violation associated with the safe trajectory, adjusting the control inputs by issuing alternative commands, thereby augmenting a UAS control schema to prevent unsafe conditions without overriding functions of the UAS control schema; and adjusting a command based on real-time operational data that is communicated to the UAS, as described, for example, with respect to FIG. 2, FIG. 3, and FIG. 6.

Processor(s) 710 can be configured to execute a method or computer instructions which can involve selectively activating the hierarchical control layer, in response to detecting a safety risk or trajectory deviation within a planning horizon, to ensure compliance with the safety requirement, as described, for example, with respect to FIG. 3 and FIG. 6.

Some portions of the detailed description are presented in terms of algorithms and symbolic representations of operations within a computer. These algorithmic descriptions and symbolic representations are the means used by those skilled in the data processing arts to convey the essence of their innovations to others skilled in the art. An algorithm is a series of defined steps leading to a desired end state or result. In example implementations, the steps carried out require physical manipulations of tangible quantities to achieve a tangible result.

Unless specifically stated otherwise, as apparent from the discussion, it is appreciated that throughout the description, discussions utilizing terms such as "processing," "computing," "calculating," "determining," "displaying," or the like, can include the actions and processes of a computer system or other information processing device that manipulates and transforms data represented as physical (electronic) quantities within the computer system's registers and memories into other data similarly represented as physical quantities within the computer system's memories or registers or other information storage, transmission or display devices.

Example implementations may also relate to an apparatus for performing the operations herein. This apparatus may be specially constructed for the required purposes, or it may include one or more general-purpose computers selectively activated or reconfigured by one or more computer programs. Such computer programs may be stored in a computer-readable medium, such as a computer-readable storage medium or a computer-readable signal medium. A computer-readable storage medium may involve tangible mediums such as optical disks, magnetic disks, read-only memories, random access memories, solid-state devices, drives, or any other types of tangible or non-transitory media suitable for storing electronic information. A computer-readable signal medium may include mediums such as carrier waves. The algorithms and displays presented herein are not inherently related to any particular computer or other apparatus. Computer programs can involve pure software implementations that involve instructions that perform the operations of the desired implementation.

Various general-purpose systems may be used with programs and modules in accordance with the examples herein, or it may prove convenient to construct a more specialized apparatus to perform desired method steps. In addition, the example implementations are not described with reference to any particular programming language. It will be appreciated that a variety of programming languages may be used to implement the techniques of the example implementations as described herein. The instructions of the programming language(s) may be executed by one or more processing devices, e.g., central processing units (CPUs), processors, or controllers.

As is known in the art, the operations described above can be performed by hardware, software, or some combination of software and hardware. Various aspects of the example implementations may be implemented using circuits and logic devices (hardware), while other aspects may be implemented using instructions stored on a machine-readable medium (software), which if executed by a processor, would cause the processor to perform a method to carry out implementations of the present application. Further, some example implementations of the present application may be performed solely in hardware, whereas other example implementations may be performed solely in software. Moreover, the various functions described can be performed in a single unit, or can be spread across a number of components in any number of ways. When performed by software, the methods may be executed by a processor, such as a general-purpose computer, based on instructions stored on a computer-readable medium. If desired, the instructions can be stored on the medium in a compressed and/or encrypted format.

Moreover, other implementations of the present application will be apparent to those skilled in the art from consideration of the specification and practice of the techniques of the present application. Various aspects and/or components of the described example implementations may be used singly or in any combination. It is intended that the specification and example implementations be considered as examples only, with the true scope and spirit of the present application being indicated by the following claims.

## Claims

1. A system for generating safe control for an unmanned aerial system (UAS), the system comprising:
a scenario generator configured to output candidate trajectories for a UAS based on one or more system constraints;
a machine learning-based plant simulator configured to use the candidate trajectories and historical UAS data to simulate a UAS behavior under one or more conditions along each trajectory and to generate a simulated trajectory for each;
a model checker configured to:
use a Boolean logic or a temporal logic to convert a safety requirement from natural language into a safety classification that is machine-readable and improved through incremental learning with new data presented;
evaluate the simulated trajectory in real time against the safety classification; and
apply the safety classification to UAS dynamics to identify a subset of trajectories as safe trajectories;
a UAS control schema that, in response to receiving the safe trajectories and control inputs associated therewith, uses a control input processor to translate each safe trajectory into actuator commands and communicates these to a UAS actuator to adjust a UAS parameter to guide the UAS along a safe trajectory;
a hierarchical control layer configured to monitor real-time operational parameters of the UAS and, in response to detecting a potential safety violation associated with the safe trajectory, adjusts the control inputs by issuing alternative commands, thereby augmenting the UAS control schema to prevent unsafe conditions without overriding functions of the UAS control schema; and
a communication interface that enables real-time feedback among the hierarchical control layer, the model checker, and the control input processor to adjust a command based on real-time operational data that is communicated by the model checker to the UAS, wherein the hierarchical control layer is selectively activated when a safety risk or trajectory deviation is identified within a planning horizon to ensure compliance with the safety requirement.

2. The system of claim 1, further comprising a logging system configured to record control decisions, safety classifications, trajectory data, real-time operational adjustments, and historical UAS data, which comprises at least one of control input data, the trajectory data, or an environmental factor, to enable a post-mission analysis of control performance.

3. The system of claim 2, wherein simulating the UAS dynamics comprises using historical trajectory data and real-time operational data from one or more UAS sensors, which comprise at least one of LiDAR, RADAR, GPS/GNSS, or an optical flow sensor.

4. The system of claim 3, wherein the machine learning-based plant simulator is updated using the real-time operational data from UAS sensors to improve dynamic modeling accuracy under differing environmental conditions.

5. The system of at least one of the previous claims, wherein the one or more system constraints comprise at least one of a regulation or a policy that comprises at least one of an obstacle avoidance, a path planning, an actuator limit, or a flight dynamic, the UAS parameter comprising at least one of a speed limit, an altitude restriction, a distance from obstacles, a weather condition, or an orientation.

6. The system of at least one of the previous claims, wherein the alternative commands are pre-approved by the model checker.

7. The system of at least one of the previous claims, wherein simulating the UAS behavior comprises simulating a state variable that comprises at least one of a position, an orientation.

8. The system of at least one of the previous claims, wherein outputting the subset of trajectories comprises communicating corresponding control inputs to the UAS control schema.

9. The system of at least one of the previous claims, wherein the machine learning-based plant simulator is trained on historical control input sequences and corresponding UAS trajectories.

10. The system of at least one of the previous claims, wherein the hierarchical control layer comprises a lower-level control layer that directly interacts with a UAS actuator and a higher-level control layer that manages trajectory planning, and reverts to an on-board UAS controller when no unsafe behavior is detected.

11. The system of at least one of the previous claims, wherein the hierarchical control layer communicates with the model checker to obtain real-time feedback on the safety of an ongoing UAS operation, the hierarchical control layer being capable of operating in both manual override and autonomous modes depending on a level of detected risk.

12. The system of at least one of the previous claims, wherein the machine learning-based plant simulator incorporates actuator saturation limits and UAS constraints into dynamic modeling to ensure realistic control simulations.

13. A method for generating safe control for an unmanned aerial system (UAS), the method comprising:
based on one or more system constraints, generating candidate trajectories for a UAS;
using the candidate trajectories and historical UAS data to simulate a UAS behavior under one or more conditions along each trajectory and to generating a simulated trajectory for each;
using a Boolean logic or a temporal logic to convert a safety requirement from natural language into a safety classification that is machine-readable format and improved through incremental learning with new data presented;
evaluating the simulated trajectory in real time against the safety classification;
applying the safety classification to UAS dynamics to identify a subset of trajectories as safe trajectories
in response to receiving the safe trajectories and control inputs associated therewith, translating each safe trajectory into actuator commands and to communicate the actuator commands to a UAS actuator to adjust a UAS parameter to guide the UAS along a safe trajectory;
monitoring real-time operational parameters of the UAS using a hierarchical control layer and, in response to detecting a potential safety violation associated with the safe trajectory, adjusting the control inputs by issuing alternative commands, thereby augmenting a UAS control schema to prevent unsafe conditions without overriding functions of the UAS control schema;
adjusting a command based on real-time operational data that is communicated to the UAS; and
in response to detecting a safety risk or trajectory deviation within a planning horizon, selectively activating the hierarchical control layer to ensure compliance with the safety requirement.

14. The method of claim 13, further comprising logging control decisions, safety classifications, trajectory data, real-time operational adjustments, and the historical UAS data, including at least one of control input data, trajectory data, or environmental factors, to enable a post-mission analysis of control performance.

15. The method of claim 14, further comprising simulating the UAS dynamics using historical trajectory data and real-time operational data from UAS sensors, including at least one of LiDAR, RADAR, GPS/GNSS, or optical flow sensors, to improve accuracy in dynamic modeling.

16. The method of claim 15, further comprising training a machine learning-based plant simulator on historical control input sequences and corresponding UAS trajectories to enhance model reliability.

17. The method of claim 16, further comprising using real-time the real-time operational data to update the machine learning-based plant simulator and improve dynamic modeling accuracy under varied environmental conditions.

18. The method of at least one of the previous claims 13 to 17, further comprising incorporating actuator saturation limits and UAS constraints into dynamic modeling to ensure realistic control simulations.

19. The method of at least one of the previous claims 13 to 18, further comprising converting safety requirements from certification, regulatory, or operational standards into machine-readable Boolean or temporal logic statements to facilitate safety compliance evaluation within a model checker.

20. The method of at least one of the previous claims 13 to 19, further comprising selecting candidate control inputs based on pre-trained Boolean logic classifiers, which assess trajectory safety in real time to retain only those control inputs associated with the safe trajectories.
